(19)

Europäisches
Patentamt
European
Patent Office
Office européen
des brevets

(11) **EP 4 753 375 A1**

(12) **EUROPEAN PATENT APPLICATION**

(43) Date of publication:
**03.06.2026 Bulletin 2026/23**

(21) Application number: **25219661.3**

(22) Date of filing: **01.12.2025**

(51) International Patent Classification (IPC):
**H05H 1/24** *(2006.01)* **B23K 3/08** *(2006.01)*

(52) Cooperative Patent Classification (CPC):
**H05H 1/24; B23K 3/08; H05H 1/4645;** B23K 1/008;
H05H 2245/10

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **02.12.2024 CN 202411755317**

(71) Applicant: **L'Air Liquide, Société Anonyme pour
l'Etude
et l'Exploitation des Procédés Georges Claude
75007 Paris (FR)**

(72) Inventor: **WU, Wentan
201108 Shanghai (CN)**

(74) Representative: **Air Liquide
L'Air Liquide S.A.
Direction de la Propriété Intellectuelle
75, Quai d'Orsay
75321 Paris Cedex 07 (FR)**

(54) **DEVICE AND METHOD FOR PLASMA ATMOSPHERE CONTROL**

(57) The present application discloses a device and method for atmosphere control using plasma, intended for removing contaminants within an at least partially enclosed chamber (100), method whereby a reactive gas is delivered to a plasma generation system, the generated plasma being introduced into the at least partially enclosed chamber (100) so that the plasma diffuses and reacts with the contaminants in the chamber (100) until the contaminant concentration is reduced to below a predetermined value, the technical solution being particularly suitable for applications where the atmosphere in the partially enclosed chamber (100) needs to be quickly switched and rapidly reduced to extremely low oxygen levels.

**Fig. 1**

EP 4 753 375 A1

## Description

## Technical Field

The present invention relates to a device and a method for controlling the atmosphere in a chamber. More specifically, it relates to a device and method for removing contaminants, such as residual oxygen, from a chamber to control the atmosphere. Specifically, it relates to a device and a method for plasma atmosphere control.

## Background

Many processes, such as reflow soldering, require an atmosphere with extremely low oxygen content. Usually it is necessary to fill the inert gas for protection so that the packaged components are exposed to an environment with reduced oxygen and moisture levels. This environment can be a vacuum, a nitrogen-filled chamber, or a room. In processes where residual oxygen level, (ROL) is highly sensitive, residual oxygen levels must be controlled below 5 ppm. Reducing residual oxygen concentration is generally achieved through gas exchange with inert gas (e.g., pure nitrogen). As the residual oxygen concentration decreases, the efficiency of inert gas exchange decreases. Although exchange efficiency may significantly improve in certain vacuum furnaces, these furnaces are extremely expensive. Some vacuum furnaces can cost up to five times the price of atmospheric pressure furnaces.

U.S. Patent No. US9539672B2 discloses a portable device for monitoring and controlling oxygen levels in the atmosphere of a reflow soldering furnace. The device includes a nitrogen injection flow control unit, a sampling and analysis unit. A reflow soldering furnace is a heating device used to weld electronic components onto printed circuit boards via surface mount technology (SMT). There may be some waste or deficiency of nitrogen in the atmosphere of a reflow soldering furnace. This deficiency results in high oxygen levels in the welding environment/surroundings, which may cause welding defects such as open circuits, solder balls, or short circuits. This portable device is designed to control oxygen concentration below 3,000 ppm in the reflow soldering environment. During monitoring, if the device detects excessive oxygen in the reflow soldering furnace environment, such as oxygen levels exceeding the user's pre-set level, then the device automatically injects additional nitrogen into the furnace until the pre-set level is achieved.

Chinese Patent No. CN101268411B discloses a method for manufacturing an electronic device. The roughness and material of the inner surface of the heating device significantly affect the content of impurities such as oxygen and moisture in the heating atmosphere. Controlling the residual oxygen content in the heating atmosphere is effective for improving the transparency of thermosetting resins. The atmosphere is replaced with an inert gas, and the residual oxygen concentration in the atmosphere is controlled to below 10 ppm. When the residual oxygen concentration exceeds 10 ppm, the oxidation degradation of thermosetting resins begins, resulting in reduced transparency.

## Summary of the Invention

The general objective of the present disclosure is to expose the space and atmosphere within a chamber to plasma treatment to remove residual oxygen, thereby achieving atmosphere control.

The first aspect of the present application provides a method for atmosphere control using plasma to remove contaminants, in particular residues, within an at least partially enclosed chamber, comprising:

delivering a reactive gas to a plasma generation system so as to generate plasma,
introducing the generated plasma into the at least partially enclosed chamber;
diffusing the plasma in the chamber; and
allowing the plasma to react with the contaminants in the chamber until the concentration of the contaminants in the chamber is reduced to below a predetermined value.

The reactive gas may advantageously comprise at least one reducing gas, optionally in combination with at least one inert gas.

The contaminants may be or comprise residues, The contaminants may in particular include oxygen, such as residual oxygen.

The predetermined value may, for example, be 500 ppm, preferably 200 ppm, more preferably 100 ppm, even more preferably as low as 50 ppm, and optimally 10 ppm, or even 5 ppm, of the atmosphere in the chamber.

The reactive gas may comprise at least one inert gas. The reactive gas may in particular comprise at least one inert gas selected from the group consisting of nitrogen, helium and argon.

When the reactive gas comprises at least one reducing gas, the reactive gas preferably comprises at least one reducing gas selected from the group consisting of hydrogen and methane, the reducing gas preferably being or including hydrogen.

Advantageously, the volume fraction of reducing gas in the reactive gas is in the range of 0.1% to 4%, preferably 1% to 3%.

For example, when the inert gas in the reactive gas is nitrogen and the reducing gas is hydrogen, a plasma torch is configured to generate a plasma of hydrogen and nitrogen. The hydrogen ions and some free radicals rapidly react with residual oxygen present in the chamber, quickly reducing the amount of residual oxygen in the device.

The method according to the present invention may also comprise a step of forming or preparing the reactive gas from a mixture of gases, whereby the mixture may include a reducing gas, an inert gas or a combination of both said gases.

For example, the reactive gas may be supplied by or prepared using a cylinder supply system. The cylinders may store an inert gas and a reducing gas, and can also reduce the pressure of the gas(es) from a high-pressure in the cylinders to the required working pressure via a pressure reducing valve, and then deliver reactive gas to the point of use via pipelines.

The second aspect of the present application provides a device for performing atmosphere control using plasma, the device comprising:

an at least partially enclosed chamber, the chamber comprising a top, a side wall, and a bottom wall, collectively defining the internal volume of the chamber;

a plasma generation system for generating plasma and for introducing the thus generated plasma into the at least partially enclosed chamber, so that the plasma diffuses and reacts with contaminants in the chamber, The plasma generation system of the device is used to generate plasma and to introduce the generated plasma in the chamber until the contaminant concentration is reduced to a predetermined value.

The plasma generation system advantageously includes a plasma torch, the nozzle of which is mounted at the top of the chamber.

The device preferably further comprises at least one fan, the at least one fan being advantageously symmetrically distributed at the top of the chamber.

Compared with the prior art, the technical solutions provided by the present invention has the following advantages:

1. The technical solution of the present invention addresses the issue of low efficiency in conventional inert gas replacement, such as the need to reduce residual oxygen concentration to below 1000 ppm over an extended period. Therefore, the technical solution of the present invention is particularly suitable for applications requiring rapid atmosphere switching and rapid reduction to extremely low oxygen concentrations.

2. The technical solution of this invention can operate at ambient temperature and pressure, thereby reducing equipment costs.

3. The technical solution of this invention is particularly suitable for applications that require adjustment of local atmosphere distribution, such as improving the balance of oxygen and nitrogen diffusion in reflow soldering, or in other packaging component processes.

### Brief description of the drawings

The advantages and spirit of the present invention can be further understood through the detailed description of the invention and the figures.

Figure 1 is a schematic diagram of the chamber used in Example 1 and Comparative Example 1.

Figure 2 shows the residual oxygen level over time in the chamber in accordance with Example 1 and Comparative Example 1.

Key to the drawings: 100 represents the chamber, 101 represents the top of the chamber, 102 represents the side wall, 103 represents the bottom wall, 104 represents the fan, and 105 represents the nozzle of the plasma torch.

### Preferred embodiments of the invention

The present application will now be described in detail with reference to the figures. However, the present application should not be understood as being limited to the following description and the technical concept of the present application may be implemented in combination with other known technologies or other technologies having the same functions as those known technologies.

In the following description of the specific embodiments, directional terms are used for clarity in illustrating the structure and operation. However, terms such as "front", "rear", "left", "right", "outer", "inner", "outward", "inward", "axial" and "radial" should be understood as convenient terms and not as limiting terms.

In the following specific examples, it should be understood that the terms "length", "width", "upper", "lower", "front", "rear", "left", "right", "vertical", "horizontal", "top" "bottom", "inner", "outer" and other terms indicating direction or positional relationships are based on the direction or positional relationships shown in the figures and are provided solely for the purpose of simplifying the description. They are not intended to indicate or imply that the devices or elements referred to must have a specific direction, be constructed in a specific direction, or operate in a specific direction. Therefore, they should not be construed as limiting the scope of this application. Furthermore, when the first structure is described as being positioned "above" or "below" the second structure, this should be understood to mean that the first structure is positioned farther away from or closer to the horizontal plane.

Furthermore, the terms "first" and "second" are used solely for descriptive purposes and do not imply any limitation on the order of time, quantity, or importance. They should not be interpreted as indicating or implying relative importance or the number of technical features indicated, but are merely used to distinguish one technical feature from another in this technical solution. Accordingly, features defined as "first" or "second" may explicitly or implicitly include one or more of such features. In the description of this application, "multiple" means two or more, unless otherwise explicitly specified. Similarly, similar terms such as "one" in this document do not refer to a limitation on quantity but describe technical features that have not been previously mentioned. Similarly, unless a noun is modified by a specific quantity word, it should be regarded as including both singular and plural forms in this document. In this technical solution, it may include either a single instance of the technical feature or multiple instances of the technical feature. Similarly, modifiers similar to "approximately" or "roughly" appearing before numerals in this document typically include the base number, and their specific meaning should be understood in context.

It should be understood that, in this application, "at least one (item)" refers to one or more, and "multiple" refers to two or more. "And/or" is used to describe the relationship between associated objects, indicating that three relationships may exist. For example, "A and/or B" may indicate: only A exists, only B exists, or both A and B exist simultaneously, where A and B may be singular or plural. The character "/" generally indicates that the objects before and after it are in an "or" relationship. "At least one of the following" or similar expressions refer to any combination of these items, including any combination of single or multiple items. For example, "at least one of a, b, or c" can represent: a, b, c, "a and b", "a and c", "b and c" or "a and b and c", where a, b, and c can be singular or plural.

The terms "unit", "piece", "item" and "module" as used in this specification refer to units that perform at least one function or operation and may be implemented using hardware components, software components, or a combination thereof.

The terms "high pressure" and "medium pressure" mean that high pressure is higher than medium pressure, so the difference between the two may be relatively small.

The terms "high temperature" and "low temperature" mean that high temperature is higher than low temperature, so the difference between the two may be relatively small.

Plasma, the fourth state of matter, is an electrically neutral ionized gas. Any gas can be converted into plasma by applying sufficient energy to it, thereby producing a large amount of charged particles, namely electrons and ions. Plasma possesses some characteristics of gases but differs from ordinary gaseous states. Plasma responds to electric and magnetic fields and these properties are caused by the presence of charged particles in the plasma state.

A plasma generation system equipped with a plasma nozzle, suitable for implementing the methods described herein, such as the plasma torch sold by Plasmatreat GmbH. For example, the Openair-Plasma® plasma torch may be used to generate and apply low-temperature plasma to the product or chamber being treated. The plasma is generated through discharge between the stator and rotor inside the plasma torch. The generated plasma is delivered through the nozzle to the exterior of the plasma torch.

Depending on the trigger voltage, power input, trigger method, and electric field configuration, in some embodiments, the plasma power is less than or equal to approximately 6500 W, further less than or equal to approximately 1000 W, and further from approximately 200 W to approximately 600 W. The plasma frequency may be any suitable frequency. In some embodiments, the plasma has a frequency in the range of approximately 200 kHz to 30 MHz. In some embodiments, the plasma frequency is less than or equal to approximately 20 MHz, less than or equal to approximately 10 MHz, less than or equal to approximately 5 MHz, less than or equal to approximately 1000 kHz, or less than or equal to approximately 500 kHz. In some embodiments, the plasma frequency is greater than or equal to approximately 210 kHz, greater than or equal to approximately 250 kHz, greater than or equal to approximately 600 kHz, greater than or equal to approximately 750 MHz, greater than or equal to approximately 1200 kHz, greater than or equal to approximately 2 MHz, greater than or equal to approximately 4 MHz, greater than or equal to approximately 7 MHz, greater than or equal to approximately 12 MHz, greater than or equal to approximately 15 MHz, or greater than or equal to approximately 25 MHz. In one or more embodiments, the plasma has a frequency of approximately 13.56 MHz, or approximately 350 kHz, or approximately 400 kHz, or approximately 27 MHz, or approximately 40 MHz, or approximately 60 MHz.

The chamber used in this specification is at least partially enclosed. The contaminants in such chambers are typically residues. Such contaminants may, for example, be present in the chamber prior to its first use, for example residues arising from the production or storage of the chamber, following a previous use of the chamber, for example residues of the process previously performed in the chamber, or even residual contaminants remaining in the chamber following another process for removing said contaminants from the chamber, for example by gas exchange/displacement with inert gas as described in the example.

As used in this specification, the term "residual" is used as the adjective form of "residue".

The present invention is suitable for removing a wide range of contaminants. Such contaminants include, for example, one or more of the following: oxygen, nitrogen, carbon, or halogens (e.g., fluorine, chlorine, bromine, or iodine).

In some embodiments, the contaminants comprise or are oxygen.

"At least partially enclosed" refers to either fully or partially enclosed.

Although the present invention is described with reference to a chamber as shown in the attached drawings, the present invention may be implemented in other types of enclosed or partially enclosed chambers. Furthermore, the chamber need not be dedicated and it may be combined with other chambers, and multiple operations may be performed in the same or different chambers.

The device and method of the present application enable the rapid consumption of contaminants, such as, in particular, residual oxygen in the atmosphere of the chamber.

In what follows, the invention is illustrated with reference to an example whereby oxygen is the contaminant to be removed from the chamber.

From an economic cost perspective, the first step may optionally involve using an inert gas to displace the atmosphere, thereby causing a first reduction in the residual oxygen level in the atmosphere of the chamber. The type of inert gas is not specifically limited. The inert gas may be selected in function of the purpose for in which the chamber is used, such as, for example, reflow soldering. Examples of possible inert gases are nitrogen, helium, neon, argon, krypton and xenon and mixtures of at least two of said gases.

Once the residual oxygen level in the chamber has been reduced to a reasonable range by the abovementioned displacement method, the second step involves further removing residual oxygen below a predetermined value using by adding a reducing gas to an inert gas and by generating a plasma of the resulting gas mixture. The volume fraction of the reducing gas ranges from 0.1% to 4%, with an optimal range of 1% to 3%. The type of reducing gas used in this invention is not particularly limited, provided it can react with the residual oxygen through oxidation. Common reducing gases include carbon monoxide, methane, ammonia, or hydrogen. However, from the perspective of achieving reduction effects and high purity, hydrogen is preferred.

The step or removing residual oxygen using generated plasma is continued until the residual oxygen level in the atmosphere of the chamber is below a predetermined value. The predetermined value of residual oxygen level in the atmosphere may, for example, be 500 ppm, preferably 200 ppm, more preferably 100 ppm, and optimally 50 ppm or even 10 ppm or below. This predetermined value of residual oxygen level may be adjusted by those skilled in the art based on the operating conditions of the chamber, process requirements, and economic budget.

Ultra-low residual oxygen level refers to levels typically below 100 ppm, preferably 50 ppm or even below 10 ppm, more preferably below 5 ppm or 1 ppm.

Unless clearly stated otherwise, each aspect or embodiment described herein may be combined with any other one or more aspects or one or more embodiments. Specifically, any feature indicated as preferred or advantageous may be combined with any other feature indicated as preferred or advantageous.

Specific embodiments of the present invention are described in detail below with reference to the figures. The embodiments may span multiple views of the figures. The same reference numerals generally denote the same or corresponding elements in the embodiments. Therefore, the description of the embodiments incorporates into each other, and the description of the common subject matter of the embodiments is generally not repeated here.

Some embodiments of methods for removing residual oxygen from a chamber are provided. However, the methods disclosed herein or other methods shown and/or described herein may be shown and/or described as a series of actions or events. It should be understood that the order in which these actions or events are shown should not be interpreted as limiting. For example, some actions may be performed in a different order and/or simultaneously with the actions or events shown and/or described in this disclosure. Additionally, not all of the actions shown are necessary to implement one or more aspects or embodiments of this disclosure, and one or more actions of this disclosure may be performed as one or more separate actions and/or stages.

As a plasma initiation device, a plasma generation system usually includes a high-voltage power supply, electrodes, and a trigger. The high-voltage power supply provides the required electrical energy. The electrodes generate an arc or plasma. The trigger controls the start and stop of the arc. Taking a plasma nozzle as an example, its design depends on the specific application requirements. A plasma nozzle typically consists of an inlet, a mixing chamber, and an outlet. The inlet of the plasma nozzle introduces the gas mixture. The mixing chamber of the plasma nozzle mixes the gas mixture with the energy required to excite the plasma. The plasma generated in the plasma nozzle releases through the outlet of the nozzle.

As illustrated herein, the chamber is at ambient temperature and pressure. The instrument used to measure oxygen concentration in the chamber is not specifically limited. Oxygen analyzers familiar to those skilled in the art, such as fuel cell-based trace oxygen analyzers, can measure residual oxygen level.

The initial atmosphere is defined as the atmosphere in which the residual oxygen level exceeds a certain range, i.e., the oxygen concentration in the initial atmosphere is 200,000 ppm. The objective is to reduce the residual oxygen level in the atmosphere to 50 ppm.

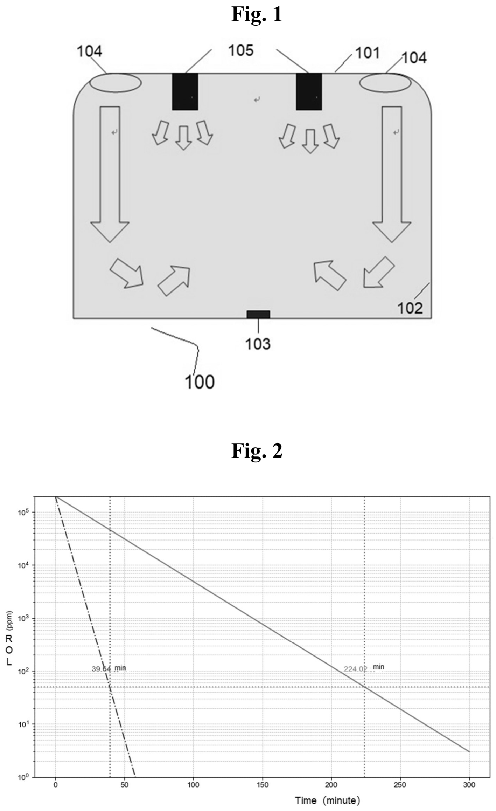

The following Example 1 implements the above-mentioned scheme of this application for plasma deoxygenation (de-oxygen). The following Comparative Example 1 employs the conventional nitrogen replacement method. Figure 2 shows the kinetic curves of the two methods.

**Example** 1:

A glove box with a volume of 810 L is used as the chamber.

Figure 1 illustrates a schematic diagram of the plasma treatment chamber according to some embodiments. The chamber 100 generally includes a top 101, a side wall 102, and a bottom wall 103, which together define the internal volume of the plasma treatment chamber. At least one nozzle of the plasma torch 105 is mounted on the top 101 of the chamber, allowing reactive gas exiting the nozzle 105 to be introduced into the chamber 100. The nozzles of the plasma torch 105 symmetrically distribute within the chamber 100. Typically, chambers 100 with a volume of 1,000 L or less are equipped with 1 to 2 plasma torch.

Reactive gases containing inert gases and reducing gases can be supplied to the plasma torch. Reactive gases can be supplied from a storage tank containing one or more raw materials. Reactive gases exposed to the plasma source generate plasma, including free radicals, ions, and other active substances of the reactive gases. The reactive gases are introduced into the chamber 100 through the nozzle 105 of the plasma torch to consume residual oxygen in the chamber 100. Free radicals, ions, and other active substances can be circulated within the chamber 100 by the rotation of the fan 104. The circulating plasma is distributed uniformly around the chamber 100 at a sufficient speed to effectively react with residual oxygen while minimizing the formation of dead zones. The configuration of the fan 104 is adjusted according to the internal conditions of the chamber 100. For example, the fan 104 is symmetrically distributed at the top of the chamber 100.

The initial concentration of oxygen in the initial atmosphere $[O_2]_0$ is 200,000 ppm. The desired final residual oxygen concentration $[O_2]$ is 50 ppm. Assuming that the plasma combustion rate constant k is 0.00289 s^-1, where d $[O_2]/dt = -k \times [O_2]$.

A mixture of hydrogen and nitrogen is used as the reactive gas. The total flow rate of the reactive gas F=30 L/min. The hydrogen content in the reactive gas is 4%. Depending on the power of the plasma torch, the conversion ratio of the reactive gas to plasma is set to 30%. That is, it is assumed that 30% of the mixture is converted into plasma capable of reacting with residual oxygen. As is known to those skilled in the art, although the plasma deoxygenation process generates a small amount of water vapor, there are many efficient and cost-effective methods available to remove this water vapor.

Therefore, the hydrogen flow rate F_$H_2$= 0.04 $\times$ 30 L/min = 1.2 L/min.

Hydrogen plasma flow rate F_$H_2$ (plasma) = 0.3 $\times$ 1.2 L/min = 0.36 L/min.

The above plasma reacts with residual oxygen. Considering the dilution effect, the effective rate constant is:

$$K_{(effective)} = k + F / V = 0.00289 + (30/60)/810 \approx 3.51 \times 10^{-3} \text{ s}^{-1}$$

After the plasma is introduced into the chamber, nitrogen replacement and hydrogen plasma deoxygenation reactions occur simultaneously within the chamber.

The equation of the change of concentration of oxygen consumed by hydrogen plasma over time is: $O_2 = [O_2]_0 e^{(-K_{(effective)} \times t)}$
The equation of the change in oxygen concentration consumed by nitrogen replacement is: $O_2 = [O_2]_0 e^{(-F/V \times t)}$.

As shown in the dashed line graph in Figure 2, under the simultaneous occurrence of nitrogen replacement and hydrogen plasma deoxygenation reactions, the residual oxygen level decreases from 200,000 ppm to 50 ppm in 39.64 minutes.

**Comparison Example 1:**

The same chamber configuration as in Example 1 is used. Nitrogen is introduced into the chamber to replace residual oxygen and then removed from the chamber. This process creates a controlled atmosphere acceptable to many processes. Maintaining a constant purging rate ensures that the residual oxygen level continues to decrease. Some commercial furnaces from Carbolite Gero utilize this principle.

As shown in the solid line graph in Figure 2, if the final target residual oxygen level is 50 ppm, the nitrogen replacement method alone would require 240.02 minutes to complete. However, using the plasma deoxygenation reaction achieves the same result in just 39.64 minutes. The solution proposed in this application addresses the issue of low efficiency when using only inert gas replacement, particularly in situations requiring rapid removal of residual oxygen from the atmosphere, and is especially suitable for applications demanding extremely low residual oxygen level.

The embodiments of the invention as described in this specification are merely preferred specific examples of the present invention. The above embodiments are provided to illustrate the technical solutions of the present invention and are not intended to limit the scope of the present invention.

## Claims

1. A method for atmosphere control using plasma to remove contaminants within an at least partially enclosed chamber (100), **characterized in that** the method comprises:

   - delivering a reactive gas to a plasma generation system so as to generate plasma therewith,
   - introducing the generated plasma into the chamber (100);
   - diffusing the plasma in the chamber (100) and
   - allowing the plasma to react with the contaminants in the chamber (100) until the concentration of the contaminants in the chamber (100) is reduced to below a predetermined value.

2. The method according to claim 1, **characterized in that** the reactive gas comprises a reducing gas and optionally also an inert gas.

3. The method according to claim 2, **characterized in that** the reactive gas comprises at least one reducing gas selected from the group consisting of hydrogen and methane, the reactive gas preferably comprising hydrogen.

4. The method according to claim 2 or 3, **characterized in that** the volume fraction of the reducing gas in the reactive gas is in the range of 0.1% to 4%, preferably 1% to 3%.

5. The method according to any one of the preceding claims, **characterized in that** the contaminants include or consist of oxygen, in particular residual oxygen.

6. The method according to any one of the preceding claims, **characterized in that** the predetermined value is 200 ppm, preferably 100 ppm, more preferably 50 ppm, and optimally 10 ppm of the atmosphere in the chamber (100).

7. The method according to any one of the preceding claims whereby the reactive gas comprises at least one inert gas selected from the group consisting of nitrogen, helium, and argon.

8. A device for performing atmosphere control using plasma, **characterized in that** the device comprises:

   an at least partially enclosed chamber (100), the chamber (100) comprising a top (101), a side wall (102), and a bottom wall (103), collectively defining the internal volume of the chamber (100);
   a plasma generation system for generating plasma and for introducing the plasma into the chamber (100), so that the plasma is diffused into the chamber (100) and allowed to react with contaminants present in the chamber (100)

9. The device according to claim 8, **characterized in that** the plasma generation system includes a plasma torch having a nozzle (105) which is mounted at the top of the chamber (100).

10. The device according to claim 8 or 9, **characterized in that** the device further comprises at least one fan (104), the at least one fan (104) being preferably symmetrically positioned at the top (101) of the chamber (100).

**Fig. 1**

**Fig. 2**

Europäisches
Patentamt

European
Patent Office

Office européen
des brevets

# EUROPEAN SEARCH REPORT

**Application Number**

EP 25 21 9661

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/042099 A1 (WADA MAKOTO [JP] ET AL) 9 February 2023 (2023-02-09) * figures 1-14 * * paragraph [0005] - paragraph [0119] * ----- | 1-8 | INV. H05H1/24 B23K3/08 |
| X | US 2008/283153 A1 (ZURECKI ZBIGNIEW [US] ET AL) 20 November 2008 (2008-11-20) * figures 1,6 * * paragraph [0029] - paragraph [0064] * ----- | 1,2,5-9 | |
| X | US 2022/059326 A1 (JIANG XIMAN [US]) 24 February 2022 (2022-02-24) * figure 8 * * paragraph [0059] - paragraph [0064] * ----- | 1-4,6-9 | |
| X | CN 112 923 382 A (SOUTHWESTERN INST PHYSICS) 8 June 2021 (2021-06-08) * figure 1 * * paragraph [0001] - paragraph [0051] * ----- | 8-10 | |
| A | CN 118 989 691 A (GUANGZHOU MORNSUN SCI & TECH) 22 November 2024 (2024-11-22) * the whole document * ----- | 1-10 | **TECHNICAL FIELDS SEARCHED (IPC)** H05H B23K H01J |

The present search report has been drawn up for all claims

| Place of search | Date of completion of the search | Examiner |
|---|---|---|
| The Hague | 14 April 2026 | Clemente, Gianluigi |

CATEGORY OF CITED DOCUMENTS

X : particularly relevant if taken alone
Y : particularly relevant if combined with another
 document of the same category
A : technological background
O : non-written disclosure
P : intermediate document

T : theory or principle underlying the invention
E : earlier patent document, but published on, or
 after the filing date
D : document cited in the application
L : document cited for other reasons
......................................................................................
& : member of the same patent family, corresponding
 document

EPO FORM 1503 03.82 (P04C01)

## ANNEX TO THE EUROPEAN SEARCH REPORT
## ON EUROPEAN PATENT APPLICATION NO.

EP 25 21 9661

This annex lists the patent family members relating to the patent documents cited in the above-mentioned European search report.
The members are as contained in the European Patent Office EDP file on
The European Patent Office is in no way liable for these particulars which are merely given for the purpose of information.

14-04-2026

| Patent document cited in search report | | Publication date | Patent family member(s) | | Publication date |
|---|---|---|---|---|---|
| US 2023042099 | A1 | 09-02-2023 | JP | 7422540 B2 | 26-01-2024 |
| | | | JP | 2021105199 A | 26-07-2021 |
| | | | KR | 20220116496 A | 23-08-2022 |
| | | | US | 2023042099 A1 | 09-02-2023 |
| | | | WO | 2021131480 A1 | 01-07-2021 |
| US 2008283153 | A1 | 20-11-2008 | BR | PI0803083 A2 | 16-08-2011 |
| | | | CA | 2631064 A1 | 09-11-2008 |
| | | | CN | 101307422 A | 19-11-2008 |
| | | | EP | 1991038 A2 | 12-11-2008 |
| | | | KR | 20080099822 A | 13-11-2008 |
| | | | KR | 20110058763 A | 01-06-2011 |
| | | | MY | 151853 A | 14-07-2014 |
| | | | PL | 1991038 T3 | 31-03-2015 |
| | | | SG | 148109 A1 | 31-12-2008 |
| | | | TW | 200912039 A | 16-03-2009 |
| | | | US | 2008283153 A1 | 20-11-2008 |
| US 2022059326 | A1 | 24-02-2022 | NONE | | |
| CN 112923382 | A | 08-06-2021 | NONE | | |
| CN 118989691 | A | 22-11-2024 | NONE | | |

EPO FORM P0459

For more details about this annex : see Official Journal of the European Patent Office, No. 12/82

**REFERENCES CITED IN THE DESCRIPTION**

**Patent documents cited in the description**

- US 9539672 B2
- CN 101268411 B